# EUROPEAN PATENT APPLICATION

(11) **EP 4 086 777 A1**
(43) Date of publication of application: **09.11.2022**
(21) Application number: 20890826.9
(22) Date of filing: 12.11.2020
(51) Int. Cl.: G06F 13/40

(54) **LOWER COMPUTER, CONNECTOR, LOWER COMPUTER ASSEMBLY AND COMMUNICATION SYSTEM**

(30) Priority: 20.11.2019 CN 201922012404 U
(71) Applicant: Fresenius Kabi (Nanchang) Co., Ltd., Nanchang, Jiangxi 330013 (CN)
(72) Inventor: CHEN, Weichu, Nanchang, Jiangxi 330013 (CN); LIU, Fajie, Nanchang, Jiangxi 330013 (CN); XU, Fan, Nanchang, Jiangxi 330013 (CN)
(74) Representative: Fresenius Kabi Deutschland GmbH
(86) International application number: PCT/CN2020/128222
(87) International publication number: WO 2021/098574

(57) **Abstract**

The present disclosure relates to a slave computer, a connector, a slave computer assembly, and a communication system. According to an embodiment of the present disclosure, a slave computer for connecting a device and a host computer comprises: a USB port having first to fifth pins; a power source switch connected with the first and fourth pins; an RS232 module constructed to perform, based on RS232 standard, conversion on levels of a signal to be transmitted to the device and a signal to be received from the device; a resistor connected between the fourth and fifth pins; and a power source having a positive terminal; wherein the positive terminal is connected with the first pin; the RS232 module is connected with the first pin via the power source switch; and the power source switch is constructed such that in response to a level at the fourth pin being a high level, the power source switch turns on a conductive path between the positive terminal and the RS232 module. The technical solution according to the present disclosure has at least one of the advantageous technical effects of: being electric energy saving, having a compact structure, being safe, and providing reliable communication between a device and a host computer.

## Description

This application claims the priority of a Chinese patent application No. 201922012404.3, filed with the Chinese Patent Office on November 20, 2019, titled "lower computer, connector, lower computer component and communication system", the entire content of which is incorporated herein by reference.

### TECHNICAL FIELD

The present disclosure relates generally to monitoring of a device, and more particularly to a slave computer, a connector, a slave computer assembly, and a communication system.

### BACKGROUND ART

In the field of device control, it is general to use a computer to control, monitor and maintain a device. Generally, a general-purpose computer cannot directly communicate with the device, but instead, a computer is set as a host computer, so as to implement communication between the device and the host computer via a slave computer.

### SUMMARY OF THE INVENTION

A brief summary of the present disclosure will be given below to provide a basic understanding to some aspects of the present disclosure. It should be understood that the summary is not an exhaustive summary of the present disclosure. The following summary does not intend to define a key or important part of the present disclosure, nor does it intend to limit the scope of the present disclosure. The object of the summary is only to present some concepts, in a simplified manner, as a preamble of the more detailed description that follows.

A host computer generally has various common ports, and is installed with various application software for different uses. An input/output signal of the device satisfies a specific specification. Therefore, it is tedious to provide a connection device between the device and the host computer so as to implement communication between the device and the host computer. It is desired to provide an appropriate connection scheme, such that a host computer and a slave computer are safely and efficiently connected so as to reliably communicate with each other, and to save energy.

According to an aspect of the present disclosure, there is provided a slave computer for connecting a device and a host computer, comprising: a USB port having a first pin, a second pin, a third pin, a fourth pin and a fifth pin; a power source switch connected with the first pin and the fourth pin; an RS232 module constructed to perform, based on RS232 standard, conversion on levels of a signal to be transmitted to the device and a signal to be received from the device; a resistor connected between the fourth pin and the fifth pin; and a power source having a positive terminal; wherein the positive terminal is connected with the first pin; the RS232 module is connected with the first pin via the power source switch; and the power source switch is constructed such that in response to a level at the fourth pin being a high level, the power source switch turns on a conductive path between the positive terminal and the RS232 module.

According to an aspect of the present disclosure, there is provided a connector for connecting a host computer and a slave computer, comprising: a first port for connecting the slave computer; and a second port for connecting the host computer; wherein the first port is a USB port; the USB port has a first pin, a second pin, a third pin, a fourth pin and a fifth pin; and the first pin is short-connected with the fourth pin.

According to an aspect of the present disclosure, there is provided a slave computer assembly for connecting a device and a host computer, comprising: the aforementioned slave computer; and the aforementioned connector; wherein the USB port of the slave computer and the first port of the connector are constructed to be removably, electrically connected with each other.

According to an aspect of the present disclosure, there is provided a communication system, comprising: a device; the aforementioned slave computer assembly; and a host computer; wherein the slave computer assembly is constructed such that the device is connectable to the host computer via the slave computer assembly, to implement communication between the host computer and the device.

The technical solution according to the present disclosure has at least one of the advantageous technical effects of: being electric energy saving, having a compact structure, being safe, and providing reliable communication between a device and a host computer.

It should be noted that, the effects described herein are not necessarily confined, and any effect described in the present disclosure is possible.

### BRIEFT DESCRIPTION OF THE DRAWINGS

The present disclosure could be better understood with reference to the descriptions made in combination with the appended drawings hereinafter. It should be appreciated that the appended drawings is not necessarily scaled. In the appended drawings:
FIG. 1 is a schematic block view of a slave computer according to an embodiment of the present disclosure;
FIG. 2 is a schematic block view of a connector according to an embodiment of the present disclosure;
FIG. 3 is a schematic block view of a state of connection of a connector with a slave computer according to an embodiment of the present disclosure;
FIG. 4 is a schematic block view of a connector according to an embodiment of the present disclosure;
FIG. 5 is a schematic block view of a connector according to an embodiment of the present disclosure;
FIG. 6 is a schematic block view of a slave computer assembly according to an embodiment of the present disclosure;
FIG. 7 is a schematic block view of a communication system according to an embodiment of the present disclosure; and
FIG. 8 is a schematic block view of a communication system according to an embodiment of the present disclosure.

### DETAILED DESCRIPTION OF THE EMBODIMENTS

Exemplary embodiments of the present disclosure will be described in combination with the appended drawings below. For the sake of clarity and conciseness, the specification does not describe all features of actual embodiments. However, it should be understood that in developing any such an actual embodiment, many decisions specific to the embodiment may be made, so as to achieve specific objects of a developer, and these decisions possibly vary as embodiments are different.

In addition, it should also be noted that, to avoid the present disclosure from being obscured due to unnecessary details, only those device structures closely related to the solutions according to the present disclosure are shown in the appended drawings, while other details not closely related to the present disclosure are omitted.

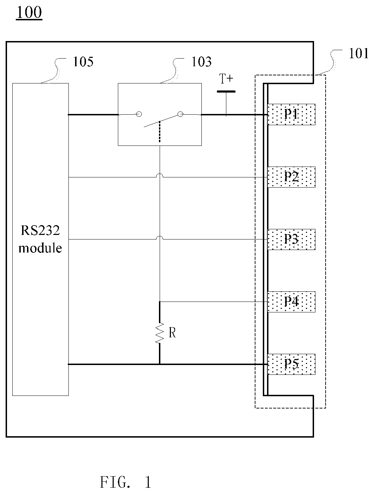

An aspect of the present disclosure relates to a slave computer for connecting a device and a host computer. The device is, for example, a medical infusion pump or nutrition pump. The host computer may be a computer installed with various software. The software is, for example, commercial software for use by hospitals or maintenance software for use by maintainers. The commercial software may be used for controlling and monitoring operating states and the like of the device. The maintenance software may be used for maintainers to maintain the device, for example to alter default parameters of the device or to debug the device. The slave computer comprises a USB port, a power source switch, an RS232 module and a power source. An exemplary description of the slave computer will be made with reference to FIG. 1 below.

FIG. 1 is a schematic block view of a slave computer 100 according to an embodiment of the present disclosure. The slave computer 100 comprises: a USB port 101, a power source switch 103, an RS232 module 105, a resistor R, and a power source. The USB port 101 has a first pin P1, a second pin P2, a third pin P3, a fourth pin P4 and a fifth pin P5. The power source switch 103 is connected with the first pin P1 and the fourth pin P4. The RS232 module is constructed to perform, based on RS232 standard, conversion on levels of a signal to be transmitted to the device (not shown in the figure) and a signal to be received from the device, such that the slave computer is capable of communicating with the device. For example, functions of the RS232 module may include implementing mutual conversion between the TTL (Logic Gate Circuit) level and the RS232 level, for example, converting a signal having the TTL level from the device to a signal having the RS232 level and transmitting the signal after the conversion outwards, and converting the signal having the RS232 level which is received to a signal having the TTL level and transmitting it to the device. The resistor R serves as a pull-down resistor. A main body of the power source is not shown in the figure, and only a positive terminal T+ of the power source is shown. For example, the positive terminal T+ may provide a voltage of 5V. As shown in FIG. 1, the positive terminal T+ is connected with the first pin P1; the fourth pin P4 is connected with the fifth pin P5 via the resistor R; the RS232 module 105 is connected with the first pin P1 via the power source switch 103; and the power source switch 103 is constructed such that in response to the level at the fourth pin P4 being the high level, the power source switch 103 turns on a conductive path between the positive terminal T+ and the RS232 module 105. That is, the fourth pin P4 provides an enable signal for switching a state of the power source switch for the power source switch 103; when the level at the fourth pin P4 is the high level, the power source switch is turned on to provide electric power to the RS232 module 105, such that the RS232 module 105 is activated; when the level at the fourth pin P4 is the low level, the power source switch 103 is disconnected, such that the RS232 module 105 is in a non-operating state due to lack of electric power. The power source switch 103 may include a metallic oxide semiconductor field effect transistor (MOS transistor), to be used as a controlled switch.

The USB port of the slave computer 100 may be various types of USB ports. To make the slave computer miniaturized or have a compact structure, the USB port may be a mini USB port.

The fifth pin P5 may be a ground (GND) pin; and the second pin P2 and the third pin P3 may be pins (PX, TX) that transmit data. That is, the second pin P2 and the third pin P3 may be used for connection with corresponding pins of the RS232 module 105 respectively, to transfer data signals.

Through the above configurations, it is possible to conveniently control the supply of electric power to the RS232 module using the level on the fourth pin P4. When it is not needed to perform communication, it is only needed to make the level on the fourth pin be the low level (e.g., zero level), and it is possible to stop the supply of electric power to the RS232 module, resulting in saving electric power.

It should be noted that, although FIG. 1 shows an exemplary, specific relative position relationship among the first pin to the fifth pin, the arrangement of the pins of the USB port of the slave computer according to the present disclosure is not limited to such a specific position relationship, and the respective pins may also be arranged according to other types of standard USB ports.

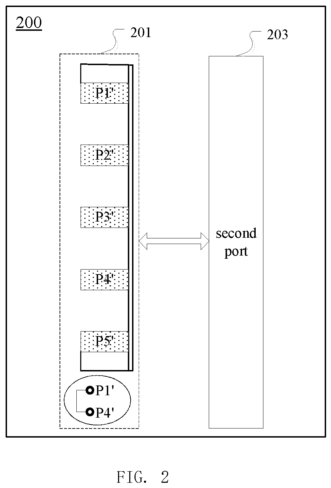

Considering that it is needed to use a matching connector when the slave computer communicates with the host computer, the present disclosure further provides such a matching connector. Considering that such a connector and the slave computer according to the present disclosure support each other in terms of function and structure, it may be regarded that such a connector and the slave computer according to the present disclosure involve the same concept, and as stated below, they have corresponding technical features. An exemplary description of a connector according to the present disclosure will be made with reference to FIG. 2 below.

FIG. 2 is a schematic block view of a connector 200 according to an embodiment of the present disclosure. The connector 200 is used for connecting a slave computer and a host computer. The connector 200 comprises: a first port 201 and a second port 203. The first port 201 is used for connecting the slave computer. The second port 203 is used for connecting the host computer. The first port 201 may be a USB port; and the USB port has a first pin P1', a second pin P2', a third pin P3', a fourth pin P4' and a fifth pin P5'. Differing from the conventional USB ports, as annotated in the dashed ellipse in FIG. 2, for use in cooperation with the slave computer according to the present disclosure, the first pin P1' of the first port 201 is short-connected with the fourth pin P4'. A cable that transmits a signal exists between the first port 201 and the second port 203, so as to implement communication between the host computer and the device. Accordingly, the USB port serving as the first port in the connector 200 is a customized USB port, but not a conventional USB port.

It should be noted that, although FIG. 2 shows an exemplary, specific relative position relationship among the first pin to the fifth pin, the arrangement of the pins of the USB port of the connector according to the present disclosure is not limited to such a specific position relationship, and the respective pins may also be arranged according to other types of standard USB ports.

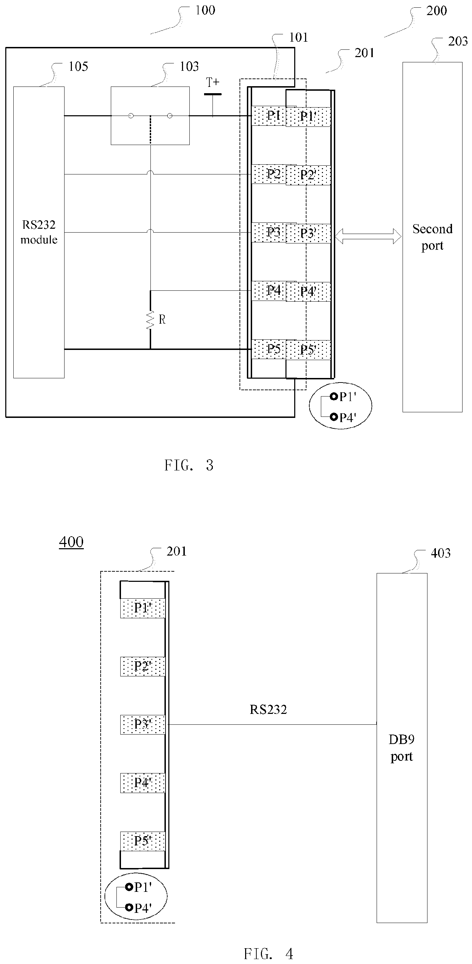

FIG. 3 is a schematic block view of a state of connection of the connector 200 with the slave computer 100 according to an embodiment of the present disclosure, wherein for the sake of clarity, the state as shown is only a state where respective pins partially contact with each other. As shown in FIG. 3, through the short-connected arrangement in the connector 200, after the first port 201 of the connector 200 is connected with the USB port 101 of the slave computer 100, the first pin P1 in the USB port 101 of the slave computer 100 is short-connected with the fourth pin P4, the fourth pin P4 is connected with the positive terminal T+, the level of the fourth pin P4 is the high level, and the power source switch 103 turns on a conductive path between the positive terminal T+ and the RS232 module 105 (i.e., as shown in FIG. 3, the power source switch 103 is in an ON state) to provide electric power needed for the operation for the RS232 module 105, so as to implement communication between the device and the slave computer. When it is not needed to perform communication between the device and the host computer, it is possible to remove the first port 201 from the slave computer, the fourth pin P4 will be in a state of being electrically disconnected with the first pin PI, the level of the fourth pin P4 becomes the low level, such that the power source switch 103 is in a disconnected state (as shown in FIG. 1), and the positive terminal T+ will no longer be able to supply power to the RS232 module. Accordingly, reasonable electric energy control is implemented.

As shown in FIG. 3, the USB port 101 and the first port 201 match with each other in terms of structure, so as to implement electrical connection in a plug-in manner. For example, in an electrical connection state, the USB port 101 serves as a socket, and the first port 201 serves as a plug.

According to the condition of the communication port of the host computer to be connected, the connector according to the present disclosure may be constructed to transmit a signal satisfying RS232 standard, without performing conversion on a signal. FIG. 4 is a schematic block view of a connector 400 according to an embodiment of the present disclosure.

As shown in FIG. 4, the connector 400 comprises a first port 201 and a DB9 port 403. That is, the DB9 port 403 is used to serve as the second port in FIG. 2. As shown in FIG. 4, a cable connection exists between the first port 201 and the DB9 port 403. The cable transmits a signal satisfying RS232 standard. The DB9 port 403 may be connected with the RS232 port of the host computer. The host computer may be a computer installed with commercial software for use by hospitals. As an example, it is possible to select to use three wires to connect three pins (e.g., pin 2, pin 3 and pin 5) of the DB9 port 403 with the second pin P2', the third pin P3' and the fifth pin P5' of the first port 201, respectively, wherein the two wires connecting the second pin P2' and the third pin P3' are constructed as a twisted pair.

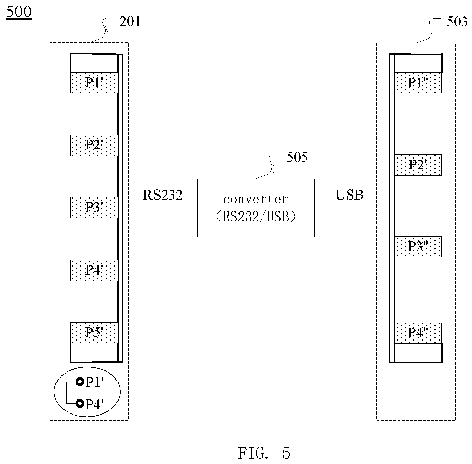

According to the condition of the communication port of the host computer to be connected, the connector according to the present disclosure may transmit a signal satisfying RS232 standard, and in this case, it is needed to perform conversion on a signal satisfying RS232 standard from the slave computer so as to ensure the safety of the host computer. FIG. 5 is a schematic block view of a connector 500 according to an embodiment of the present disclosure.

As shown in FIG. 5, the connector 500 comprises a first port 201, a USB A-type port 503, and a converter 505 between the first port 201 and the USB A-type port 503. The converter 505 is used for implementing conversion between a signal satisfying RS232 standard and a signal satisfying USB standard. Electric power needed for the operation of the converter 505 may come from the positive terminal T+ in FIG. 1. The USB A-type port 503 has a first pin PI", a second pin P2", a third pin P3" and a fourth pin P4". The host computer may be a computer installed with software for maintaining the device. The USB A-type port 503 is a conventional USB A-type port, so as to facilitate connection with a USB port on a general-purpose computer. Selecting such a USB A-type port 503 is also advantageous to lowering costs and ensuring the generality of the connector.

That is, the connector 200 in FIG. 2 may be embodied as the connector 400 in FIG. 4 or the connector 500 in FIG. 5.

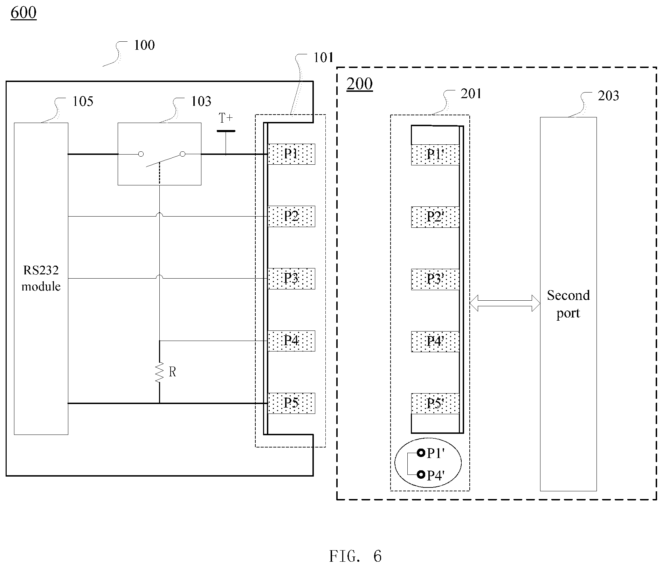

The present disclosure relates also to a slave computer assembly for connecting a device and a host computer. An exemplary description of the slave computer assembly according to the present disclosure will be made with reference to FIG. 6 below.

FIG. 6 is a schematic block view of a slave computer assembly 600 according to an embodiment of the present disclosure. As shown in FIG. 6, the slave computer assembly 600 comprises the slave 100 and the connector 200. The USB port 101 of the slave computer 100 and the first port 201 of the connector 200 are constructed to be removably, electrically connected with each other. FIG. 6 shows a state when the slave computer 100 and the connector 200 are not in electrical connection. When the USB port 101 and the first port 201 are connected, the first pins P1 and P1' contact with each other; the second pins P2 and P2' contact with each other; the third pins P3 and P3' contact with each other; the fourth pins P4 and P4' contact with each other; and the fifth pins P5 and P5' contact with each other.

With reference to the figures below, an overall arrangement of communication connection according to the present disclosure will be exemplarily described. The overall arrangement forms a communication system comprising: a device, a slave computer assembly, and a slave computer; wherein the slave computer assembly is constructed such that the device is connectable to the host computer via the slave computer assembly, to implement communication between the host computer and the device. Through communication, it is possible to implement monitoring and controlling of the slave computer by the host computer.

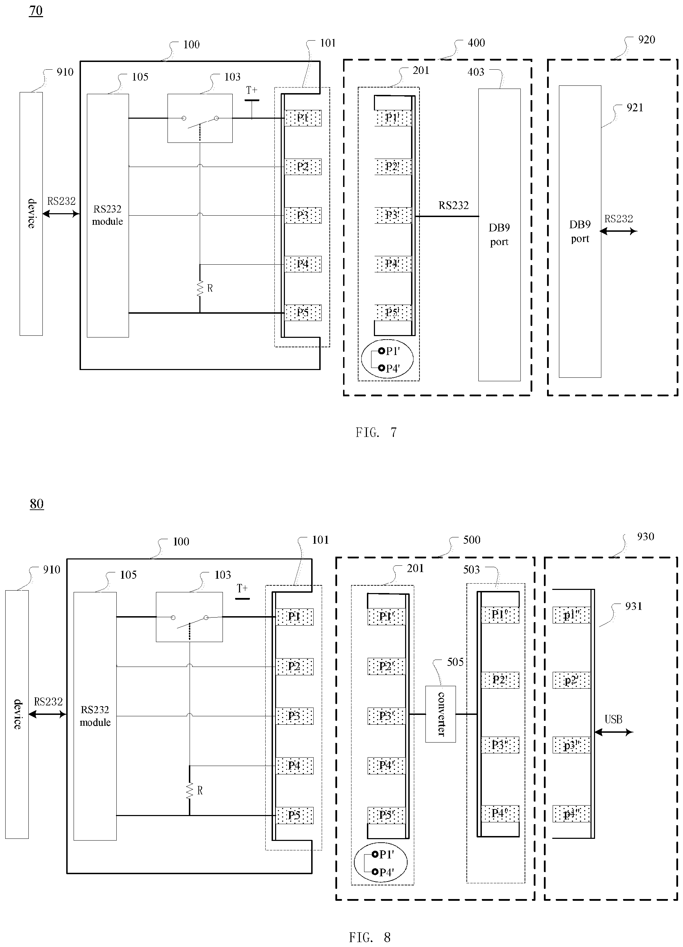

FIG. 7 is a schematic block view of a communication system 70 according to an embodiment of the present disclosure. As shown in FIG. 7, the communication system comprises a device 910, the slave computer 100, the connector 400 and a host computer 920, wherein the slave computer 100 and the connector 400 form a slave computer assembly. The slave computer 100 is constructed such that the device 910 is connectable with the slave computer 100 to communicate with each other based on RS232 standard. For example, a start bit, data bits and a stop bit(s) of a signal output from the device 910 satisfy RS232 standard, and the level of the signal is a TTL level; and after the signal is subjected to a treatment by the RS232 module of the slave computer, the level of the signal becomes the RS232 level. For example, the TTL level is a logic level within 5 V, wherein a level above 2.0 V represents "1", and a lever below 0.8 V represents "0"; and as to RS232 level, a level of -3 to -15 V represents "1", and a level of 3 to 15 V represents "0". The slave computer 100 is connected with the connector 400 to transmit a signal between each other according to RS232 standard, wherein the USB port 101 and the first port 201 are constructed to be contactable with each other for electrical connection. The connector 400 is connected with the host computer 920 to transmit a signal between each other according to RS232 standard, wherein the DB9 port of the connector 400 and the DB9 port 921 of the host computer 920 are constructed to be contactable with each other for electrical connection. As shown in FIG. 7, the DB9 port 921 of the host computer transmits a signal satisfying RS232 standard. Accordingly, the slave computer assembly is constructed such that the device 910 is connectable to the host computer 920 via the slave computer assembly, so as to implement communication between the host computer 920 and the device 910. Through communication, it is possible to implement monitoring and controlling of the slave computer 910 by the host computer 920.

FIG. 8 is a schematic block view of a communication system 80 according to an embodiment of the present disclosure. As shown in FIG. 8, the communication system 80 comprises the device 910, the slave computer 100, the connector 500 and the host computer 930, wherein the slave computer 100 and the connector 500 form a slave computer assembly. The slave computer assembly is constructed such that the device 910 is connectable with the slave computer 100 to communicate with each other based on RS232 standard. For example, a start bit, data bits and a stop bit(s) of a signal output from the device 910 satisfy RS232 standard, and the level of the signal is a TTL level; and after the signal is subjected to a treatment by the RS232 module of the slave computer, the level of the signal becomes the RS232 level. For example, the TTL level is a logic level within 5 V, wherein a level above 2.0 V represents "1", and a lever below 0.8 V represents "0"; and as to RS232 level, a level of -3 to -15 V represents "1", and a level of 3 to 15 V represents "0". The slave computer 100 is connected with the connector 500 to transmit a signal between each other according to RS232 standard, wherein the USB port 101 and the first port 201 are constructed to be contactable with each other for electrical connection. The connector 500 is connectable with the host computer 930 via the converter 505 and the USB A-type port 503 to communicate with each other according to USB standard, wherein the USB A-type port 503 of the connector 500 and the USB A-type port 931 of the host computer 930 are constructed to be contactable with each other for electrical connection. The USB A-type port 931 has a first pin p1", a second pin p2", a third pin p3" and a fourth pin p4". As shown in FIG. 8, the USB A-type port 931 of the host computer 930 transmits a signal satisfying USB standard. Accordingly, the slave computer assembly is constructed such that the device 910 is connectable to the host computer 920 via the slave computer assembly, so as to implement communication between the host computer 920 and the device 910. Through communication, it is possible to implement monitoring and controlling of the slave computer 910 by the host computer 920.

Even if the slave computer according to the present disclosure is erroneously inserted into a conventional USB connection line, the host computer will not have a danger, that is, the host computer will be safe. The reason for this is that in a case where the slave computer is connected with a conventional USB connection line, the level of the fourth pin of the USB port of the slave computer is the low level, and thus the power source switch is in a disconnected state, such that the RS232 module will not operate and no signal satisfying RS232 standard will be transmitted to the host computer. In this case, the slave computer will not consume electric energy due to an erroneous operation.

In addition, when it is not needed that the slave computer communicates with the host computer (for example, the slave computer is used to only provide electric power), the slave computer still can be used, without needing to insert the connector according to the present disclosure into the slave computer. Therefore, the functions of the slave computer according to the present disclosure will not be reduced or weaken due to customization.

As shown above, the inventor obtains the slave computer and the connector according to the present disclosure by effectively reforming the conventional slave computer and connector. The slave computer and the connector according to the present disclosure can be used in cooperation, so as to implement reliable, safe and efficient communication between the device and the host computer, while being capable of reasonably saving electric energy.

It should be understood that the different embodiments or features described herein may be combined, where feasible, unless otherwise indicated.

It should be emphasized that when being used herein, terms "include/comprise" indicate existence of features, elements or assemblies, without excluding existence or addition of one or more other features, elements or assemblies.

Although the present disclosure has been disclosed above by describing the detailed embodiments of the present disclosure, it should be understood that those skilled in the art could carry out various modifications, improvements or equivalents for the present disclosure within the spirit and scope of the appended claims. Such modifications, improvements or equivalents should also be regarded as being included within the scope of protection of the present disclosure.

## Claims

1. A slave computer for connecting a device and a host computer, comprising:
a USB port having a first pin, a second pin, a third pin, a fourth pin and a fifth pin;
a power source switch connected with the first pin and the fourth pin;
an RS232 module constructed to perform, based on RS232 standard, conversion on levels of a signal to be transmitted to the device and a signal to be received from the device;
a resistor connected between the fourth pin and the fifth pin; and
a power source having a positive terminal;
wherein the positive terminal is connected with the first pin;
the RS232 module is connected with the first pin via the power source switch; and
the power source switch is constructed such that in response to a level at the fourth pin being a high level, the power source switch turns on a conductive path between the positive terminal and the RS232 module.

2. The slave computer according to claim 1, wherein the USB port is a mini USB port.

3. The slave computer according to claim 1, wherein the fifth pin is a ground pin.

4. The slave computer according to claim 1, wherein the second pin and the third pin are connected with corresponding pins of the RS232 module respectively, to transfer data signals.

5. A connector for connecting a host computer and a slave computer, comprising:
a first port for connecting the slave computer; and
a second port for connecting the host computer;
wherein the first port is a USB port;
the USB port has a first pin, a second pin, a third pin, a fourth pin and a fifth pin; and
the first pin is short-connected with the fourth pin.

6. The connector according to claim 5, wherein the USB port is a mini USB port.

7. The connector according to claim 5, wherein the second port is a DB9 port.

8. The connector according to claim 5, wherein the second port is a USB A-type port.

9. The connector according to claim 8, further comprising a converter arranged between the first port and the second port;
wherein the converter is constructed to be used for implementing conversion between a signal satisfying RS232 standard and a signal satisfying USB standard.

10. A slave computer assembly for connecting a device and a host computer, comprising:
the slave computer according to claim 1; and
the connector according to any one of claims 6 to 9;
wherein the USB port of the slave computer and the first port of the connector are constructed to be removably, electrically connected with each other.

11. A communication system, comprising:
a device;
the slave computer assembly according to claim 10; and
a host computer;
wherein the slave computer assembly is constructed such that the device is connectable to the host computer via the slave computer assembly, to implement communication between the host computer and the device.
